# FASCICULE DE BREVET EUROPEEN

(11) **EP 1 095 407 B1**
(45) Date de publication et mention de la délivrance du brevet: **10.09.2008**
(21) Numéro de dépôt: 99925075.6
(22) Date de dépôt: 14.06.1999
(51) Int. Cl.: H01L 27/12, H01L 21/84, H01L 21/762, H01L 29/786

(54) **CIRCUIT INTEGRE DE TYPE SOI A CAPACITE DE DECOUPLAGE, ET PROCEDE DE REALISATION D'UN TEL CIRCUIT**
INTEGRIERTER SOI-SCHALTKREIS MIT ENTKOPPLUNGSKONDENSATOR UND DESSEN HERSTELLUNGSVERFAHREN
INTEGRATED SILICON-ON-INSULATOR INTEGRATED CIRCUIT WITH DECOUPLING CAPACITY AND METHOD FOR MAKING SUCH A CIRCUIT

(30) Priorité: 15.06.1998 FR 9807495
(43) Date de publication de la demande: 02.05.2001
(73) Titulaire: COMMISSARIAT A L'ENERGIE ATOMIQUE, 75015 Paris (FR)
(72) Inventeur: BELLEVILLE, Marc, F-38120 St. Egrève (FR); BRUEL, Michel, F-38113 Veurey (FR)
(74) Mandataire: Weber, Etienne Nicolas
(86) Numéro de dépôt international: PCT/FR1999/001403
(87) Numéro de publication internationale: WO 1999/066559

(56) Documents cités:
- EP-A- 0 694 977
- DE-A- 4 441 724
- US-A- 5 378 919
- YOSHINO A ET AL: "HIGH-SPEED PERFORMANCE OF 0.35 MUM CMOS GATES FABRICATED ON LOW- DOSE SIMOC SUBSTRATES WITH/WITHOUT AN N-WELL UNDERNEATH THE BURIED OXIDE LAYER" IEEE ELECTRON DEVICE LETTERS, vol. 17, no. 3, 1 mars 1996 (1996-03-01), pages 106-108, XP000584745

## Description

### Domaine technique

L'invention concerne une structure de circuit intégré comprenant des moyens capacitifs de découplage des bornes d'alimentation du circuit.

Elle trouve des applications dans les domaines de la micro-électronique pour la réalisation de circuits à composants MOS, MIS ou bipolaires, et permet de réduire le bruit parasite engendré sur les alimentations électriques des circuits, provoqués notamment par des appels de courant transitoires.

De façon plus précise, l'invention peut être mise à profit dans des appareils portables incluant par exemple des microprocesseurs, des circuits de téléphonie sans fil, ou dans toutes applications utilisant les technologies SOI pour leurs caractéristiques en basse consommation.

### Etat de la technique antérieure

Dans les circuits intégrés, la distribution des masses et des potentiels d'alimentation vers les dispositifs actifs, c'est-à-dire vers les transistors par exemple, est réalisée par des lignes d'alimentation en un matériau conducteur électrique. Or, lors du fonctionnement des circuits, les lignes d'alimentation doivent fournir des courants transitoires dont l'intensité peut être relativement élevée.

Selon l'intensité de ces courants, mais aussi selon leur localisation, les courants transitoires sont susceptibles de générer un bruit parasite sur les lignes et le système d'alimentation.

De façon générale, dans les circuits électroniques, on utilise des condensateurs de filtrage connectés entre les bornes des systèmes d'alimentation pour diminuer le bruit parasite, et placés le plus près possible de la source de courant transitoire.

Dans le domaine de l'électronique intégrée la réalisation des condensateurs de filtrage peut poser problème. Cependant, la structure de certains types de circuits intégrés, tels que les circuits CMOS (Metal-Oxyde-Semiconducteur-Complémentaires) sur substrat massif, permet de découpler naturellement les potentiels d'alimentation et le potentiel de masse.

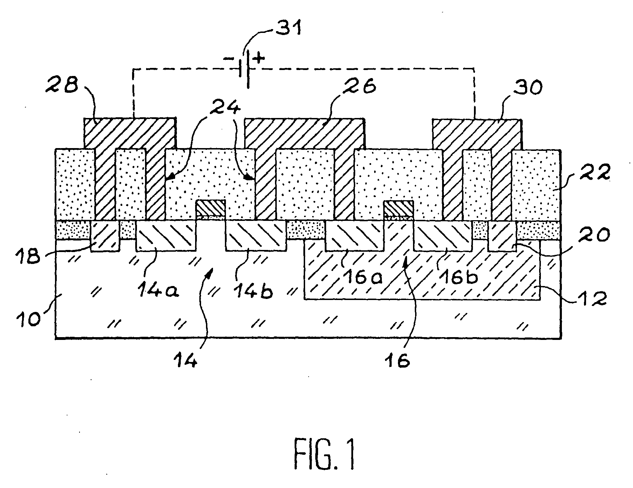

La figure 1 est une coupe schématique d'une portion de circuit intégré de type CMOS usuel.

Sur cette figure, la référence 10 désigne un substrat massif de silicium du type de conductivité P. Dans ce substrat est formé un caisson 12 de type N. Les références 14 et 16 désignent des transistors à effet de champ réalisés respectivement dans le substrat de type P et dans le caisson de type N.

Des zones actives fortement dopées 14a, 14b, 16a, 16b, 18 et 20 forment respectivement les sources et drains des transistors à effet de champ 14, 16, et des prises de contact pour les régions de type P et N.

La zone active 18, de type P⁺ est en contact avec le substrat de type P et la zone active 20 de type N⁺ est en contact avec le caisson de type N.

Une épaisse couche d'isolant électrique 22 recouvre le substrat et les composants 14, 16 qui y sont réalisés. Cette couche est traversée par des ouvertures 24 emplies d'un matériau conducteur électrique permettant de relier les zones actives à des pistes conductrices 26, 28, 30 formées au-dessus de la couche d'isolant électrique 22. Les ouvertures emplies de matériau conducteur électrique sont encore appelées "vias".

Les vias permettent de relier des zones actives entre elles. Ceci est le cas, par exemple, des vias connectés à la piste conductrice centrale 26 et qui relient électriquement entre elles les zones actives 14b et 16a. Les vias permettent également de relier les zones actives et/ou des régions du substrat à des bornes d'alimentation.

Sur la figure 1, les bornes d'alimentation sont constituées par les pistes conductrices 28, 30 qui sont reliées à une source de tension d'alimentation 31 représenté schématiquement en trait discontinu.

La piste conductrice 28 constitue une borne de masse. Elle est reliée à la zone active 14a du premier transistor 14, et au substrat 10 par l'intermédiaire de la zone active 18. Une deuxième borne d'alimentation, formée par la piste conductrice 30, est reliée notamment au caisson 12 par l'intermédiaire de la zone active 20.

Le caisson 12 forme avec le substrat 10 une jonction semi-conductrice qui présente une certaine capacité de jonction et qui se trouve connectée entre les bornes d'alimentation 28, 30, en parallèle avec les composants.

La capacité de la jonction caisson-substrat permet de filtrer ainsi l'alimentation et de réduire le bruit parasite dû à des appels de courant.

Il existe d'autres types de structures CMOS, à caissons N, à caissons P, ou à double caissons. Des capacités de jonction formées entre les caissons et le substrat permettent généralement d'obtenir un découplage intrinsèque entre la borne de masse et les autres bornes d'alimentation.

Un certain nombre de circuits intégrés réalisés actuellement ne sont cependant pas formés sur un substrat massif, comme évoqué ci-dessus, mais sont formés dans une couche mince d'un support présentant une structure de type silicium sur isolant. Une telle structure, usuellement désignée par "SOI" (silicon On Insulator), comporte une couche de matériau isolant électrique, par exemple d'oxyde, qui sépare la couche mince de silicium d'une partie massive du support. La réalisation de circuits intégrés sur des substrats de type SOI permet d'augmenter la densité d'intégration, de réduire les capacités parasites et d'améliorer les performances des circuits en termes de fréquence de fonctionnement et de consommation.

Dans le cas des circuits réalisés sur des substrats SOI, l'isolation entre les différents composants ou zones actives est réalisée par des zones d'oxyde.

Ainsi, le découplage entre les masses et les autres bornes d'alimentation, qui se fait par l'intermédiaire du substrat dans les structures sur substrat massif, est beaucoup plus faible dans les circuits réalisés sur des substrats de type SOI.

Un bruit plus important est donc observé dans ces circuits. Ce problème est exposé par exemple dans le document (1) dont la référence est précisée à la fin de la présente description.

Une solution possible pour réduire le bruit parasite consiste à ajouter au circuit intégré, formé dans la couche mince de la structure SOI, des capacités de découplage. Ces capacités peuvent être réalisées en utilisant la capacité de grille d'un ou de plusieurs transistors. A titre d'exemple, on peut utiliser un transistor de type NMOS dont la grille est reliée à une borne d'alimentation et dont la source et le drain sont connectés à la masse. Une capacité de meilleure qualité peut être obtenue par une implantation adaptée du canal d'un tel transistor.

Cependant, les transistors ou autres capacités dédiés au découplage des bornes d'alimentation sont placés sur la structure SOI à côté des transistors formant la partie fonctionnelle du circuit intégré. Ils occupent ainsi une place utile, ce qui conduit à une augmentation de la surface totale des puces électroniques.

On peut se référer à ce sujet aux documents (2) et (3) dont les références sont précisées à la fin de la description. Le document (2) montre en particulier l'utilisation d'un condensateur de découplage.

Un arrière-plan technologique de l'invention est aussi illustré par le document (4). Celui-ci montre la réalisation d'un condensateur enterré.

### Exposé de l'invention

La présente invention a pour but de proposer un circuit intégré formé dans une couche mince isolée d'un substrat, tel que par exemple une couche mince d'un substrat SOI, ne présentant pas les limitations mentionnées ci-dessus.

Un but est en particulier de proposer un circuits incluant des moyens pour découpler les bornes d'une ou de plusieurs alimentations, qui permettent de réduire efficacement le bruit parasite des alimentations.

Un but est encore de proposer un tel circuit utilisant une surface de puce réduite.

Pour atteindre ces buts, l'invention a plus précisément pour objet un circuit intégré selon la revendication 1.

Au sens de la présente invention, on entend par zone active une zone de la couche mince présentant un type de dopage déterminé. Un circuit électronique peut comporter un très grand nombre de zones actives qui peuvent constituer notamment des parties de transistors telles que les sources ou les drains des transistors.

Par ailleurs, le circuit peut être alimenté en énergie par une ou plusieurs alimentations. On désigne par borne d'alimentation un élément conducteur relié à une alimentation et dont le potentiel est fixé par ladite alimentation. Une borne d'alimentation particulière est la borne de masse.

Grâce à l'invention, comme les moyens capacitifs de découplage ne sont pas réalisés dans la couche mince, ils ne réduisent pas la place disponible pour les composants fonctionnels du circuit intégré, c'est-à-dire pour les zones actives.

Selon l'invention, la région comportant les moyens capacitifs de découplage s'étend au moins en partie en-dessous de la zone active ou des zones actives du circuit intégré.

Cette caractéristique permet de contribuer encore davantage à la réduction de la surface totale de la puce comportant le circuit.

Les moyens capacitifs de découplage de l'invention peuvent comporter une ou plusieurs capacités à diélectrique. On désigne par capacité à diélectrique une capacité formée de façon comparable à un condensateur, c'est-à-dire avec deux armatures en un matériau conducteur électrique, séparées par un matériau isolant électrique.

Ainsi, la région du substrat isolée de la couche mince peut comporter au moins une première et au moins une deuxième couches de matériau conducteur électrique, électriquement isolées l'une de l'autre, présentant respectivement au moins une face en regard, et reliées respectivement aux première et deuxième bornes d'alimentation.

Les première et deuxième couches de matériau conducteur, par exemple en silicium dopé ou en silicium polycristallin, peuvent être séparées par une couche d'oxyde de silicium.

Selon un perfectionnement de l'invention, les moyens capacitifs de découplage peuvent comporter au moins une couche conductrice électrique formant une armature de condensateur, et connectée à au moins une zone active pour relier ladite zone active à une borne d'alimentation.

L'utilisation des moyens de découplage pour distribuer une alimentation électrique aux zones actives est non seulement très favorable pour diminuer encore davantage les bruits parasites, mais permet aussi de libérer une place importante pour réaliser des pistes d'interconnexion des parties actives et de transport des signaux. Ces pistes sont généralement formées sur un côté de la couche mince opposé à la partie massive du substrat SOI.

L'invention concerne également un procédé de réalisation d'un circuit intégré selon la revendication 1 équipé de moyens capacitifs à diélectrique. Ce procédé comporte les étapes successives suivantes :
a) formation sur un substrat comprenant une première couche conductrice, dans l'ordre à partir de la surface, une première couche isolante et une deuxième couche conductrice,
b) mise en forme de la deuxième couche conductrice pour laisser subsister au moins une portion de la deuxième couche conductrice séparée de la première couche conductrice par la première couche isolante,
c) formation d'une deuxième couche isolante enrobant la portion de la deuxième couche conductrice,
d) réalisation sur la deuxième couche isolante d'une couche mince de matériau semi-conducteur,
e) formation dans la couche mince d'au moins un composant comprenant au moins une zone active et oxydation de la couche mince entre les composants,
f) formation sur la couche mince d'une couche isolante électrique épaisse,
g) formation d'ouvertures traversant la couche isolante épaisse, la couche mince, et la couche de matériau isolant électrique en dehors des composants pour atteindre les première et deuxième couches conductrices,
h) mise en place de matériau conducteur dans les ouvertures, et formation des interconnexions électriques pour relier les première et deuxième couches conductrices respectivement à des première et deuxième bornes d'alimentation électrique.

L'étape g) peut également comporter la formation d'ouvertures traversant la couche isolante épaisse pour atteindre des zones actives de la couche mince, ces ouvertures étant aussi emplies de matériau conducteur électrique pour relier entre elles sélectivement des zones actives ou pour relier des zones actives aux bornes d'alimentation électrique.

D'autres caractéristiques et avantages de la présente invention ressortiront mieux de la description qui va suivre, en référence aux figures des dessins annexés. Cette description est donnée à titre purement illustratif et non limitatif.

### Brève description des figures

- La figure 1, déjà décrite, est une coupe schématique d'une portion de circuit intégrée CMOS de type connu réalisée sur un substrat de silicium massif.
- Les figures 2 à 8 sont des coupes schématiques simplifiées illustrant des étapes successives de fabrication d'un circuit intégré conforme à l'invention.

### Description détaillée de modes de mise en oeuvre de l'invention

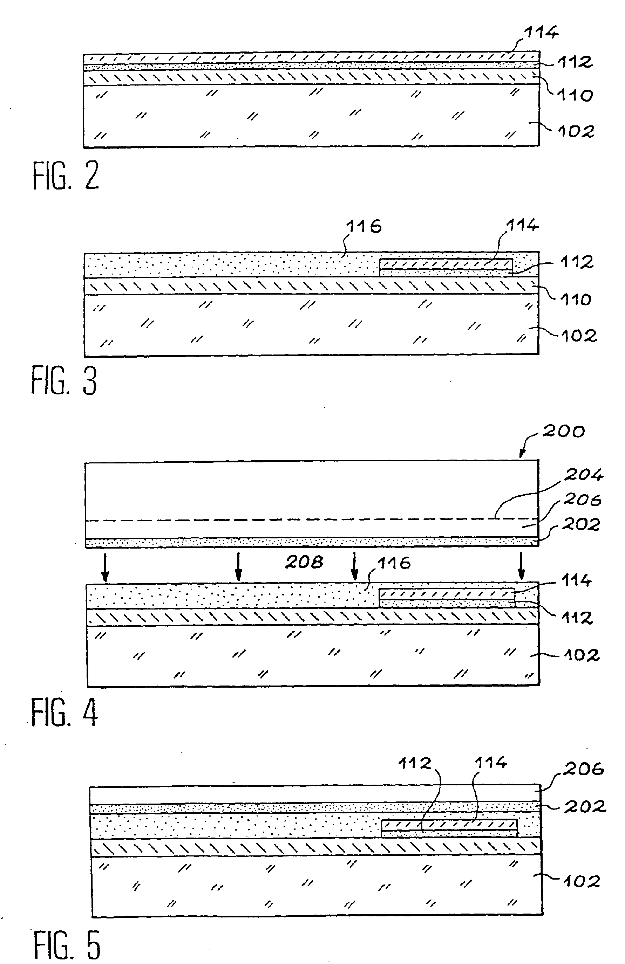

La figure 2 montre un substrat 100 de type N dans lequel on a formé une première couche conductrice 110 fortement dopée N⁺. Cette couche 110 est formée par exemple par implantation d'arsenic avec une dose de 3.10¹⁵ cm⁻², suivie d'un recuit à 950°C pendant 1 heure.

Sur la première couche conductrice 110 sont successivement formées une première couche d'oxyde 112 et une deuxième couche conductrice 114. La couche d'oxyde 112 est formée par croissance avec une épaisseur de 15 nm, par exemple.

La deuxième couche 114, conductrice, est une couche de silicium polycristallin dopé N⁺ et est déposé avec une épaisseur de l'ordre de 600 nm, par exemple. (Sur la figure les épaisseurs des couches ne sont pas proportionnelles, mais représentées en échelle libre).

La première couche d'oxyde 112 et la deuxième couche conductrice 114 sont gravées avec arrêt sur la première couche conductrice 110 en silicium selon un motif permettant de préserver une portion de la deuxième couche conductrice 114 et la couche d'oxyde 112 sous-jacente.

Comme le montre la figure 3, une deuxième couche d'oxyde 116 est déposée sur le substrat de façon à encapsuler la portion de la deuxième couche conductrice 114 préservée lors de la gravure. L'épaisseur de la deuxième couche d'oxyde est par exemple de 1,5 µm.

Cette couche est rendue plane par un polissage mécanochimique lors duquel on préserve de préférence une épaisseur d'oxyde de l'ordre de 0,2 µm au-dessus du silicium polycristallin de la deuxième couche conductrice 114.

Une étape ultérieure illustrée par les figures 4 et 5 consiste à reporter sur la deuxième couche d'oxyde 116 une structure SOI comprenant une couche d'oxyde 202 et une couche superficielle mince de silicium 206. Ces couches sont reportées à partir d'un deuxième substrat 200.

Le deuxième substrat 200 est une plaque de silicium à la surface de laquelle est formée la couche superficielle d'oxyde de silicium 202. Une zone de fragilisation 204, définie par exemple par l'implantation d'ions de gaz rare ou d'azote dans le substrat 200, délimite initialement dans celui-ci la couche mince de silicium 206 en contact avec la couche superficielle d'oxyde de silicium. La zone de fragilisation 204 s'étend de façon sensiblement parallèle à la surface du deuxième substrat.

Comme l'indiquent des flèches 208 le deuxième substrat 200 est reporté sur le premier substrat 100 en tournant la couche superficielle d'oxyde 202 vers la face du premier substrat de silicium dans laquelle l'implantation a été pratiquée. Cette face est désignée par face supérieure.

La couche d'oxyde 202 est solidarisée de la face supérieure du premier substrat, par exemple, par des forces de liaison atomique.

Puis, un traitement thermique approprié permet de cliver le deuxième substrat 200 selon la zone de fragilisation 204 et de séparer la couche mince 206 du deuxième substrat.

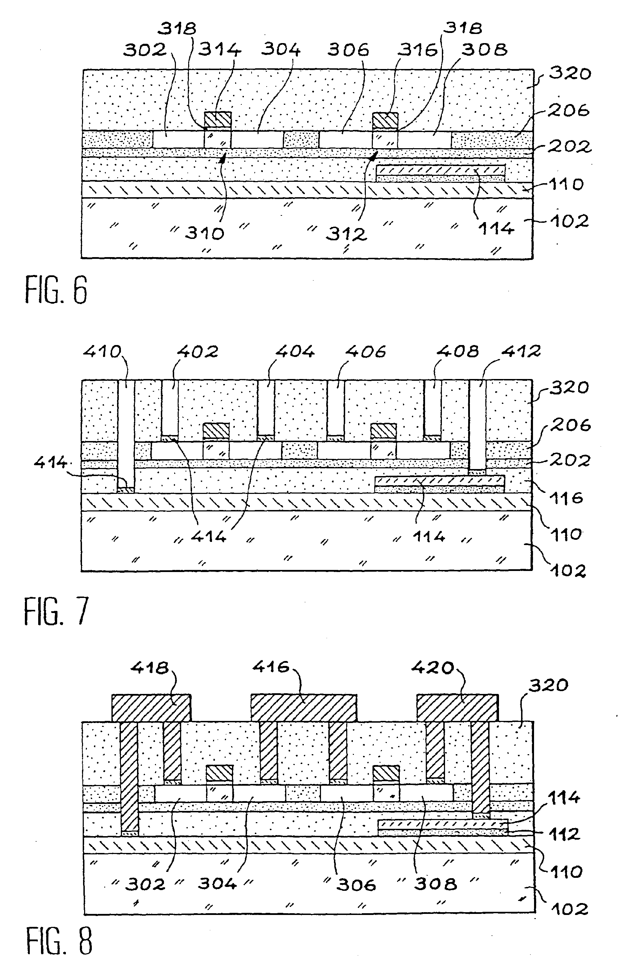

Dans la couche mince 206 sont ensuite formées des zones actives 302, 304, 306, 308 de transistors 310, 312. Les parties restantes de la couche mince sont oxydées et des grilles de transistors 314, 316 sont formées sur la couche mince. Une couche épaisse d'isolant, telle qu'une couche d'oxyde 320 est formée au-dessus de la couche mince de façon à enrober les grilles des transistors. On obtient la structure illustrée par la figure 6.

Les zones 302, 304 sont dopées N⁺ et forment les source et drain d'un premier transistor NMOS 310. Les zones 306 et 308 sont dopées P⁺ et forment les source et drain d'un deuxième transistor 312 PMOS. Les références 314, 316 désignent respectivement les grilles des transistors 306 et 308, formées sur la couche mince superficielle, par l'intermédiaire d'une couche d'oxyde de grille 318.

Les parties de la couche mince superficielle 206, situées entre les transistors 310 et 312 sont oxydées afin d'isoler mutuellement ces composants.

Enfin, comme indiqué ci-dessus, une couche isolante épaisse 320 est formée à la surface du substrat pour recouvrir entièrement les grilles.

On peut observer que l'agencement mutuel des transistors, c'est-à-dire des zones actives, et les première et deuxième couches conductrices du substrat, est tel que les zones actives chevauchent partiellement les première et deuxième couches conductrices 110, 114.

La figure 7 illustre une étape ultérieure lors de laquelle des ouvertures 402, 404, 406, 408 sont pratiquées dans la couche d'oxyde épaisse pour atteindre les zones actives 302, 304, 306, 308 respectivement.

Ces ouvertures sont pratiquées par gravure ionique réactive avec arrêt sur le silicium des zones actives. Elles présentent un diamètre de 0,5 µm par exemple.

Des ouvertures 410, 412 sont également pratiquées à travers la couche d'oxyde épaisse, à travers la couche de silicium oxydée en dehors des zones actives, à travers la couche d'oxyde 202 reportée sur le substrat, et à travers la deuxième couche d'oxyde 116 pour atteindre respectivement les première et deuxième couches conductrices 110, 114. Ces ouvertures peuvent présenter un diamètre plus fort, par exemple de 0,8 µm. Toutes les opérations d'ouverture (de 402 à 412) peuvent éventuellement être simultanées.

Les ouvertures 410, 412 atteignant les couches conductrices ne constituent pas un encombrement trop important à la surface de la puce dans la mesure ou elles sont généralement nettement moins nombreuses que les ouvertures pratiquées à l'aplomb des zones actives.

On observe par ailleurs, que toutes les ouvertures sont pratiquées à travers des matériaux électriquement isolants.

Après un nettoyage chimique du fond des ouvertures et la formation éventuellement d'une couche 414 de barrière de diffusion, par exemple en Ti/TiN, les ouvertures sont emplies d'un matériau conducteur tel que du tungstène déposé par CVD pour former des vias.

Puis, comme le montre la figure 8 des pistes conductrices sont réalisées sur la surface de la couche d'isolant épais 320. Ces pistes conductrices 416, 418, 420 sont en contact avec les vias. Elles sont formées par dépôt puis gravure selon un masque d'une couche de matériau conducteur.

La piste 418, par exemple, est connectée à la source 302 du premier transistor 310 et à la première couche conductrice 110. Elle forme avec la première couche conductrice 110 une borne d'alimentation, en l'occurrence la borne de masse.

La piste 420 qui constitue une deuxième borne d'alimentation et est reliée à la source 308 du deuxième transistor 312 et à la portion restante de la deuxième couche conductrice 114 dans le substrat.

Les première et deuxième couches conductrices 110, 114 séparées par la première couche d'oxyde 112, constituent les armatures d'un condensateur de découplage des bornes de l'alimentation.

De plus, la première couche conductrice 110 du substrat peut être utilisée comme une ligne d'alimentation, par exemple comme ligne de masse commune. Ceci est le cas dans l'exemple de la figure 8 où une zone active 302 est reliée à la première couche conductrice 110 par l'intermédiaire de vias et d'une piste conductrice 418. Une place plus importante peut alors être réservée à la surface de l'oxyde épais 320 pour réaliser des interconnexions entre composants. De manière analogue, la deuxième couche conductrice 114 peut être utilisée comme une ligne d'alimentation.

La description qui précède se réfère à des exemples de circuits réalisés avec un faible nombre de composants et avec seulement deux bornes d'alimentation. L'invention s'applique cependant également à des circuits comprenant un nombre très important de composants et de zones actives, alimentés par une pluralité de sources d'alimentation distinctes. Le nombre de bornes d'alimentation et, éventuellement, le nombre de capacités de découplage est alors multiplié.

On observe également que comme la réalisation des capacités et des zones actives sont bien distinctes, il est possible d'optimiser séparément les paramètres de fabrication de ces éléments. Ceci constitue un avantage supplémentaire par rapport aux circuits de l'art antérieur réalisé sur un substrat massif.

### DOCUMENTS CITES

*(1)* Proceedings 1995 IEEE International SOI Conference, Oct. 1995, pages 100-101 "On-chip decoupling capacitor design to reduce switching-noise-induced instability in CMOS/SOI VLSI" de L.K. Wang and Howard H. chen
*(2)* Proceedings 1996 IEEE International SOI Conference, Oct. 1996, pp. 112-113 "Simultaneous Switching noise projection for High-Performance SOI chip design" de L.K. Wang and Howard H. Chen
*(3)* 1998 IEEE International Solid-State Circuits Conference, pp. 230-231 de J. Silberman et al.
*(4)* US-A-5 378 919

## Revendications

1. Circuit intégré comprenant :
- au moins une première et une deuxième bornes d'alimentation (418, 420),
- au moins une zone active (302, 304, 306, 308) formée dans une couche mince (206) d'un substrat, et reliée électriquement à l'une au moins des bornes d'alimentation,
**caractérisé en ce qu'**il comporte en outre des moyens capacitifs de découplage formés par au moins une capacité de découplage à diélectrique (110, 112, 114) connectée entre lesdites première et deuxième bornes d'alimentation, dans une région du substrat isolée électriquement de la couche mince (206) du substrat, ladite région s'étendant au moins en partie sous la zone active.

2. Circuit selon la revendication 1, dans lequel la région du substrat isolée de la couche mince (206) comporte au moins une première et au moins une deuxième couches de matériau conducteur électrique (110, 114), électriquement isolées l'une de l'autre, présentant respectivement au moins une face en regard, et reliées respectivement aux première et deuxième bornes d'alimentation, les première et deuxième couches formant les armatures d'au moins une capacité de découplage à diélectrique.

3. Circuit selon la revendication 2, dans lequel les première et deuxième couches (110, 114) sont respectivement séparées par une couche d'oxyde de silicium (112).

4. Circuit selon la revendication 1, dans lequel ladite capacité de découplage à diélectrique comporte au moins une couche conductrice (110) électrique formant une armature, ladite couche étant connectée à au moins une zone active (302) pour relier ladite zone active à une borne d'alimentation.

5. Procédé de réalisation d'un circuit intégré selon la revendication 1 équipé de moyens de découplage capacitif de bornes d'alimentation électrique comprenant les étapes successives suivantes :
a) formation, sur un substrat (100) comprenant une première couche conductrice (110), dans l'ordre à partir de la surface, une première couche isolante (112) et une deuxième couche conductrice (114),
b) mise en forme de la deuxième couche conductrice (114) pour laisser subsister au moins une portion de la deuxième couche conductrice séparée de la première couche conductrice par la couche isolante,
c) formation d'une deuxième couche isolante (116) enrobant la portion de la deuxième couche conductrice,
d) réalisation sur la deuxième couche isolante (116) d'une couche mince (206) de matériau semi-conducteur,
e) formation dans la couche mince d'au moins un composant comprenant au moins une zone active (302, 304, 306, 308) et oxydation de la couche mince entre les composants,
f) formation sur la couche mince d'une couche isolante électrique épaisse (320),
g) formation d'ouvertures traversant la couche isolante épaisse, la couche mince (206), et la couche de matériau isolant électrique (116) en dehors des composants pour atteindre les première et deuxième couches conductrices,
h) mise en place de matériau conducteur dans les ouvertures et formation d'interconnexions électriques pour relier les première et deuxième couches conductrices respectivement à des première et deuxième bornes d'alimentation électrique.

6. Procédé selon la revendication 5, dans lequel l'étape g) comporte en outre la formation d'ouvertures traversant la couche isolante épaisse pour atteindre des zones actives de la couche mince, ces ouvertures étant également emplies lors de l'étape h) de matériau conducteur pour relier des zones actives sélectivement entre elles ou pour relier des zones actives aux bornes de l'alimentation électrique.

7. Procédé selon la revendication 5, dans lequel l'étape d) comporte le report sur le substrat d'une plaque de silicium (200) présentant une couche superficielle d'oxyde de silicium (202), la couche d'oxyde de silicium étant solidarisée de la deuxième couche isolante et la plaque de silicium étant clivée pour laisser à la surface du substrat la couche mince (206) de matériau semi-conducteur.

8. Procédé selon la revendication 5, dans lequel on effectue un polissage de la deuxième couche isolante (116) après l'étape c)

## Claims

1. Integrated circuit comprising:
- at least one first and one second power supply terminal (418, 420),
- at least one active area (302, 304, 306, 308) formed in a thin layer (206) of a substrate and electrically connected to at least one of the power supply terminals,
**characterized in that** it also comprises capacitive decoupling means formed by at least one dielectric decoupling capacitor (110, 112, 114) connected between the said first and second power supply terminals, in a region of the substrate that is electrically insulated from the thin substrate layer (206), the said region extending at least partly under the said active area.

2. Circuit according to claim 1, in which the region of the substrate insulated from the thin layer (206) comprises at least one first and at least one second layer of electrical conducting material (110, 114) each having at least one face facing, said first layer being electrically insulated from said second layer, said first and second layers being connected to first and second power supply terminals respectively and forming the foils of at least one dielectric decoupling capacitor.

3. Circuit according to claim 2, in which the first and second layers respectively (110, 114) are separated by a silicon oxide layer (112).

4. Circuit according to claim 1, in which the said dielectric decoupling capacitor comprises at least one electrical conducting layer (110) forming a foil, the said layer being connected to at least one active area (302) to connect the said active area to a power supply terminal.

5. Process for making an integrated circuit according to claim 1, equipped with capacitive means of decoupling electrical power supply terminals comprising the following steps in sequence:
a) formation of a first insulating layer (112) and a second conducting layer (114) in order, starting from the surface, on a substrate (100) comprising a first conducting layer (110),
b) formation of the second conducting layer (114) to leave at least part of the second conducting layer separated from the first conducting layer by the insulating layer,
c) formation of a second insulating layer (116) surrounding part of the second conducting layer,
d) creation of a thin layer (206) of semiconducting material on the second insulating layer (116),
e) formation of at least one component in the thin layer, comprising at least one active area (302, 304, 306, 308) and oxidation of the thin layer between the components,
f) formation of a thick electrical insulating layer (320) on the thin layer,
g) formation of openings passing through the thick insulating layer, the thin layer (206), and the layer of electrical insulating material (116) outside components to reach the first and second conducting layers,
h) placement of the conducting material in the openings, and formation of electrical interconnections to connect the first and second conducting layers to first and second electrical power supply terminals, respectively.

6. Process according to claim 5, in which step g) also comprises the formation of openings passing through the thick insulating layer to reach active areas in the thin layer, these openings also being filled in step h) with conducting material to selectively connect active areas to each other or to connect active areas to electrical power supply terminals.

7. Process according to claim 5, in which step d) comprises transferring a silicon wafer (200) with a surface layer of silicon oxide (202) onto the substrate, the silicon oxide layer being fixed to the second insulating layer and the silicon wafer being cleaved to leave the thin layer (206) of semiconducting material on the substrate surface.

8. Process according to claim 5, in which the second insulating layer (116) is polished after step c).

## Patentansprüche

1. Integrierter Schaltkreis umfassend:
- wenigstens einen ersten und einen zweiten Anschlusspunkt (418, 420),
- wenigstens eine aktive Zone (302, 304, 306, 308), die in einer dünnen Schicht (206) eines Substrats ausgebildet und mit einem der wenigstens einen Anschlusspunkte elektrisch verbunden ist,
**dadurch gekennzeichnet, dass** er außerdem kapazitive Entkopplungsmittel, die durch mindestens einen dielektrischen Kopplungskondensator (110, 112, 114) gebildet werden, der zwischen dem ersten und zweiten Anschlusspunkt angeschlossen ist, in einem von der dünnen Schicht (206) des Substrats elektrisch isolierten Bereich des Substrats umfasst, wobei sich dieser Bereich mindestens zum Teil unter die aktive Zone erstreckt.

2. Schaltkreis gemäß Anspruch 1, bei dem der von der dünnen Schicht (206) isolierte Bereich des Substrats wenigstens eine erste und wenigstens eine zweite Schicht aus elektrisch leitendem Material (110, 114) umfasst, die voneinander elektrisch isoliert sind und jeweils eine Seite gegenüber aufweisen und mit dem ersten beziehungsweise zweiten Anschlusspunkt verbunden sind, wobei die erste und zweite Schicht die Elektroden wenigstens eines dielektrischen Entkopplungskondensators bilden.

3. Schaltkreis gemäß Anspruch 2, bei dem die erste und zweite Schicht (110, 114) jeweils durch eine Siliziumoxidschicht (112) getrennt sind.

4. Stromkreis gemäß Anspruch 1, bei dem dieser dielektrische Entkopplungskondensator wenigstens eine elektrisch leitende, eine Elektrode bildende Schicht (110) umfasst, wobei diese Schicht mit wenigstens einer aktiven Zone (302) verbunden ist, um diese aktive Zone mit einem Anschlusspunkt zu verbinden.

5. Verfahren zur Herstellung eines integrierten Schaltkreises, der mit Mitteln zur kapazitiven Entkopplung elektrischer Anschlusspunkte ausgestattet ist, das die folgenden aufeinanderfolgenden Schritte umfasst:
a) Bilden in der Reihenfolge von der Oberfläche ausgehend einer ersten Isolierschicht (112) und einer zweiten leitenden Schicht (114) auf einem eine erste leitende Schicht (110) umfassenden Substrat (100),
b) Anpassen der zweiten leitfähigen Schicht (114) unter Hinterlassen wenigstens eines Teils der zweiten leitenden Schicht, die durch die Isolierschicht von der ersten leitenden Schicht getrennt ist,
c) Bilden einer zweiten Isolierschicht (116), die den Teil der zweiten leitenden Schicht umgibt,
d) Herstellen einer dünnen Schicht (206) aus Halbleitermaterial auf der zweiten Isolierschicht (116),
e) Bilden wenigstens eines Bauteils in der dünnen Schicht, das wenigstens eine aktive Zone (302, 304, 306, 308) umfasst, und Oxidation der dünnen Schicht zwischen den Bauteilen,
f) Bilden einer dicken, elektrisch isolierenden Schicht (320) auf der dünnen Schicht,
g) Bilden durch die dicke Isolierschicht, die dünne Schicht (206) und die Schicht (116) aus elektrisch isolierendem Material außerhalb der Bauteile hindurchführender Öffnungen unter Erreichen der ersten und zweiten leitenden Schicht,
h) Anbringen des leitenden Materials in den Öffnungen und Bilden elektrischer Verbindungen unter Verbinden der ersten beziehungsweise zweiten leitenden Schicht mit dem ersten und zweiten elektrischen Anschlusspunkt.

6. Verfahren gemäß Anspruch 5, bei dem Schritt g) außerdem die Bildung durch die dicke Isolierschicht hindurchführender Öffnungen unter Erreichen der aktiven Zonen der dünnen Schicht umfasst, wobei diese Öffnungen in Schritt h) auch mit leitendem Material gefüllt werden, um aktive Bereiche selektiv miteinander zu verbinden oder aktive Zonen mit elektrischen Anschlusspunkten zu verbinden.

7. Verfahren gemäß Anspruch 5, bei dem Schritt d) das Übertragen eines eine Oberflächenschicht aus Siliziumoxid (202) aufweisenden Siliziumwafers (200) auf das Substrat umfasst, wobei die Siliziumoxidschicht von der zweiten Isolierschicht getrennt ist und der Siliziumwafer unter Hinterlassen der dünnen Schicht (206) aus Halbleitermaterial auf der Substratoberfläche gespalten wird.

8. Verfahren gemäß Anspruch 5, bei dem nach Schritt c) ein Polieren der zweiten Isolierschicht (116) ausgeführt wird.
